(19) **Europäisches Patentamt / European Patent Office / Office européen des brevets**

(11) **EP 1 920 915 B1**

(12) **EUROPEAN PATENT SPECIFICATION**

(45) Date of publication and mention
of the grant of the patent:
**27.02.2019 Bulletin 2019/09**

(21) Application number: **06782075.3**

(22) Date of filing: **01.08.2006**

(51) Int Cl.:
*B32B 9/00* *(2006.01)*   *B05D 7/00* *(2006.01)*
*B32B 15/08* *(2006.01)*   *C09D 1/00* *(2006.01)*
*C23C 14/06* *(2006.01)*   *B05D 7/04* *(2006.01)*
*B32B 27/34* *(2006.01)*   *B32B 27/36* *(2006.01)*

(86) International application number:
**PCT/JP2006/315197**

(87) International publication number:
**WO 2007/020794 (22.02.2007 Gazette 2007/08)**

(54) **GAS BARRIER FILM AND METHOD FOR PRODUCING SAME**

GASSPERRFILM UND HERSTELLUNGSVERFAHREN DAFÜR

FILM FORMANT UNE BARRIÈRE CONTRE LES GAZ ET SON PROCÉDÉ DE PRODUCTION

(84) Designated Contracting States:
**AT BE BG CH CY CZ DE DK EE ES FI FR GB GR HU IE IS IT LI LT LU LV MC NL PL PT RO SE SI SK TR**

(30) Priority: **12.08.2005 JP 2005234765**

(43) Date of publication of application:
**14.05.2008 Bulletin 2008/20**

(73) Proprietor: **Toppan Printing Co., Ltd.**
**Taito-ku,**
**Tokyo 110-0016 (JP)**

(72) Inventors:
• **KAWASHIMA, Mototaka,**
**Kureha Corporation**
**Tokyo 1038552 (JP)**
• **OBA, Hiroyuki,**
**c/o Polymer Processing & Products**
**Research Laboratories**
**Omitama-shi, Ibaraki 3113436 (JP)**

• **WAKABAYASHI, Juichi,**
**Kureha Corporation**
**Tokyo 1038552 (JP)**

(74) Representative: **Hoffmann Eitle**
**Patent- und Rechtsanwälte PartmbB**
**Arabellastraße 30**
**81925 München (DE)**

(56) References cited:
**EP-A1- 1 466 725      EP-A2- 0 437 946**
**JP-A- 04 226 343      JP-A- 08 142 255**
**JP-A- 10 323 928      JP-A- 62 220 330**
**JP-A- 2002 178 438    JP-A- 2003 291 246**
**US-A- 4 364 995**

• **DATABASE WPI Week 200404 Thomson Scientific, London, GB; AN 2004-037925 XP002674082, & JP 2003 112385 A (UNITIKA LTD) 15 April 2003 (2003-04-15)**

## Description

## Technical Field

The present invention relates to a gas barrier film and a method for producing the same, and more particularly to a gas barrier film useful as, for example, a packaging material or a moisture-proof material for a planar light-emitting device (EL), a vacuum thermal insulating material, an integrated circuit (IC), foods, medicines, and materials for living ware, and to a method for producing the same.

## Background of the Invention

The packaging material for industry, food and other sectors has so far required having a function of preventing the content from deteriorating in quality. In particular, a packaging dealing with a content that would easily deteriorate in quality, the material is required to have excellent gas barrier properties such as water vapor gas barrier properties, as well as properties allowing the content to be recognized, i.e. visibility of the contents.

Accordingly, JP-A-1996-142255 discloses a moisture-proof composite film having water resistance formed with the following method. First, a dried membrane is formed on a vapor deposited film made of an inorganic-vapor deposited film, by applying thereon a solution of a mixture which contains, at a predetermined ratio, polyvinyl alcohol, and polycarboxylic acid or a partially neutralized material thereof. Thereafter, the resultant vapor deposited film is subjected to the heat-treatment at 100 °C or more to obtain the water resistance. In addition, JP-A-1996-142256 discloses a moisture-proof composite film having water resistance formed with the following method. First, a dried membrane is formed on a vapor deposited film made of an inorganic-vapor deposited film by applying thereon a solution of a mixture containing, at a predetermined ratio, polycarboxylic acid or a partially neutralized material thereof, and sugars. Thereafter, the resultant vapor deposited film is subjected to the heat-treatment at $\geq$ 100°C to obtain the water resistance.

However, the conventional moisture proof composite films described in the above patent documents do not always have sufficient moisture proofness, or sufficient properties allowing the content to be recognized, i.e. visibility.

EP-A-0 437 946 discloses a web material useful for packaging oxygen and/or moisture-sensitive substances comprises a web substrate with a coating comprising a uniform mixture of metal and metal oxide, the amount of metal being low so that the coated substrate is transparent to microwaves, and can be made by a reactive evaporation process in which an oxygen-containing gas or vapor is introduced into a vacuum chamber (X) directly into a stream of evaporating metal to deposit the mixture on the substrate (Y), the amount of oxygen being controlled to keep the amount of metal in the coating at a low level.

JP-A-1987-220330 describes a antistatic property gas barrier film providing a gas barrier layer, which barrier film includes aluminum oxide on a transparent plastic film base substance, and contains 1-15 wt.-% of aluminium .

JP-A-1996-142255 relates to a moisture-proof composite film containing at least one laminated structure wherein in a vapor deposition film of an inorganic material is formed on at least the single surface of a polymeric film base material and a water-resistant film formed from a mixture containing polyvinyl alcohol and polycarboxylic acid or a partially neutralized substance thereof in a wt. ratio of 95:5-10:90 is laminated on the vapor deposition film. Also a layer composed of a polymer composition containing a desiccant is arranged on at least one surface of the laminated structure.

## Disclosure of the Invention

In light of the problems that the above prior art has, the present invention is intended to provide a gas barrier film having sufficiently excellent visibility (properties allowing the content to be recognized) as well as advanced moisture proofness, and to provide a method for producing the same.

As a result of intensive studies for accomplishing the above object, the present inventors discovered a way of obtaining a gas barrier film with excellent gas barrier properties, and thereby achieved the completion of the present invention. Specifically, the invention provides a gas barrier film having a water vapor permeability of 0.10 $g/m^2 \cdot day$ or less at a temperature of 40°C and a relative humidity of 90% and comprising

(i) a mixture-deposited layer made of a metal and a metal oxide provided on at least one surface of a polymer film substrate, and
(ii) laminated on at least one surface of the layer (i), a resin layer formed using a polycarboxylic acid-based solution,

wherein the integration value ratio ($S_{Meo}/S_{Me}$) in the layer (i) is 1.5-100, with $S_{Me}$ and $S_{Meo}$ being the integration values of the XPS spectra of the metal and the metal oxide of the layer (i).

The excellent gas barrier is provided to the gas barrier film by laminating a resin layer formed using a polycarboxylic acid-based solution, on at least one surface of the mixture-deposited layer.

In the gas barrier film of the present invention, the metal and metal oxide of the above mixture-deposited layer are preferably aluminum, and aluminum oxide, respectively.

In addition, the present gas barrier film is preferably obtained by the method of the invention for producing the present gas barrier film, which method comprises

- forming a vapor deposited layer (i) made of a mixture of a metal and a metal oxide on at least one surface of the polymer film substrate by a vapor deposition method,
  wherein the integration value ratio ($S_{Meo}/S_{Me}$) in the layer (i) is 1.5-100, with $S_{Me}$ and $S_{Meo}$ being the integration values of the XPS spectra of the metal and the metal oxide of the layer (i);
- applying a polycarboxylic acid-based solution on the surface of the layer (i); and
- subsequently drying the solution at a temperature of 50°C or more.

The drying at a temperature of 50 °C or more serves to further oxidize the mixture-deposited layer.

The XPS (X-ray photoelectron spectroscopy) allows the atomic binding state of the sample to be known from the energy of photoelectron, the photoelectron is detected from the surface of the sample by irradiating soft X-ray. In addition, the XPS can analyze the surface of the sample from which the contaminant on the uppermost surface is removed by sputtering using rare gas ions such as Ar ions in a depth direction down to the order of submicrons. In the present invention the XPS spectrum is obtained with the analysis and measuring method (hereinafter referred to as depth profile measurement) wherein the depth profile in each chemical state is obtained by sequentially analyzing the surface composition while exposing the interior of the sample, using XPS measurement in combination with rare gas ion sputtering such as Ar, and by combining the separation of a chemical bonding state, using waveform analysis with the obtained analysis result. The XPS spectrum is also represented by a vertical axis indicating the concentration (%) in each chemical state (a metal state and a metal oxide state), and by a horizontal axis indicating a sputtering time (approximately correlates with the thickness). The integration value of the XPS spectrum of the metal of the present mixture-deposited layer is defined as $S_{Me}$. The integration value of the XPS spectrum of the metal oxide of the present mixture-deposited layer is defined as $S_{MeO}$. These values are the respective integration value determined from the XPS spectrums of the metal and metal oxide in the mixture-deposited layer. The value of the integration value ratio ($S_{Meo}/S_{Me}$) of the metal and metal oxide of the mixture-deposited layer determined from these integration values is the one representing the abundance ratio between the metal and the metal oxide in the mixture-deposited layer.

The present invention makes it possible to provide a gas barrier film having sufficiently excellent visibility and advanced moisture proofness, and to provide a method for producing the same.

**Detailed Description of the Preferred Embodiments**

The present invention will be described below in detail with regard to preferred embodiments.

First, the gas barrier film producing method of the present invention (the present method) will be described. More precisely, this is a method of obtaining the gas barrier film described below: by forming a mixture-deposited layer made of a metal and a metal oxide described below on at least one surface of the polymer film substrate described below with a deposition method; by then applying a polycarboxylic acid-based solution described below on the surface of the mixture-deposited layer described below; and by subsequently drying the solution at a temperature of $\geq$ 50 ° C (heat treatment).

The polymer film substrate in the present invention is only necessary to be the film which does not block the visibility and the moisture proofness and can include a film formed of a polymer material including, for example, polyamide such as nylon 6, nylon 66, nylon 12, nylon 6·66 copolymer, nylon 6·12 copolymer; and polyethylene terephthalate (PET), polyethylene naphthalate (PEN), polybutylene terephthalate(PBT), polycarbonate, poly4-methypenten-1, polyphenylene sulphide, polypropylene (PP), polyimide (PI), polyacrylonitrile (PAN), and polylactic acid (PLA) . The material is not particularly limited to the described above. Among these films, A PET film is particularly preferable from the viewpoint of excellent heat resistance, and low influence of humidity. These films are allowed to be an unoriented film or an oriented film, and also in a sheet form.

Although these polymer film substrates may contain various kinds of additives so as to have surface smoothness and surface stability, the amount of additives is preferably as small as possible because adhesion properties between the substrate and the deposited film is reduced if the additives are bled during vacuum deposition. In addition, the thickness of these polymer film substrates is usually 5-1,000 $\mu$m and preferably 10-100 $\mu$m, not particularly limited, from the viewpoint of softness and economic efficiency.

A metal used as the deposition source of a mixture-deposited layer of a metal and a metal oxide related to the present invention can be a metal usually used to produce a deposited film, and includes, for example, aluminum (Al), cobalt (Co), nickel (Ni), copper (Cu), zinc (Zn), silver (Ag), and the mixture of these metals. Among these metals, Aluminum is preferable from the viewpoint of visibility and oxidation easiness of the metal on the surface of the deposited layer.

A metal oxide used as the deposition source of a mixture-deposited layer of a metal and a metal oxide related to the present invention can be a metal oxide usually used to produce a deposited film, and includes, for example, aluminum oxide ($Al_2O_3$), silicon oxide ($SiO_x$, x = 1-2), silicon oxynitride ($SiO_xN_y$, x = 0.6-0.8, y = 0.7-0.9). Among these metal oxides, Aluminum oxide is preferable from the viewpoint of the moisture proofness and the formation easiness of the oxide.

The amount ratio (molar ratio) between the metal and the metal oxide in a mixture of a metal and a metal oxide in the present invention is preferably in the range of 3/2 to 100/1 (metal oxide/metal), and more preferably in the range of 5/1 to 20/1. When the amount ratio (molar ratio) between a metal oxide and a metal is less than the lower limit described above, the moisture proofness of the obtained gas barrier film tends to be insufficient. On the other hand, when the ratio exceeds the above upper limit, the flex resistance of the obtained gas barrier film tends to be reduced.

The polycarboxylic acid-based solution in the present invention refers to the solution of the existing polycarboxylic acid-based polymer or the solution of the partially neutralized material of the existing polycarboxylic acid-based polymer. Such a polycarboxylic acid-based polymer is only necessary to be a polymer having at least two carboxyl groups in the molecule and can be, for example, the homopolymer of unsaturated carboxylic acid monomer such as acrylic acid, methacrylic acid, maleic acid, itaconic acid, crotonic acid and fumaric acid; the copolymer of two kinds or more of the unsaturated carboxylic acids; a mixture of two or more kinds of these homopolymers and/or the copolymers (hereinafter occasionally collectively referred to as "polycarboxylic acid"); and the copolymer of the unsaturated carboxylic acid monomer and an ethylene-based monomer (such as ethylene and styrene),not particularly limited. Among these polycarboxylic acid-based polymers, the homopolymer of acrylic acid, the homopolymer of methacrylic acid, and the copolymer of acrylic acid and methacrylic acid are preferable from the viewpoint of the gas barrier properties of the obtained film. The homopolymer of acrylic acid, and the copolymer of acrylic acid and methacrylic acid containing a dominant amount of acrylic acid are particularly preferable.

The number-average molecular weight of such a polycarboxylic acid-based polymer is preferably in the range of 2, 000-10, 000, 000, and more preferably 5,000-1,000,000, and particularly preferably 10, 000-1, 000, 000 . When the number-average molecular weight of the polycarboxylic acid-based polymer is less than the lower limit described above, the moisture proofness of the obtained gas barrier film tends to be insufficient. On the contrary, when the molecular weight exceeds the upper limit, the coating properties tend to be deteriorated.

Such a partially neutralized material of the polycarboxylic acid-based polymer is not particularly limited, but can be, for example, the one obtained by partially neutralizing the carboxylic group of the polycarboxylic acid-based polymer using an alkali to convert the same to a carboxylate. Such an alkali can be, for example, sodium hydroxide, lithium hydroxide, potassium hydroxide, and ammonia (including ammonia water). The partially neutralized material of the polycarboxylic acid-based polymer can have a desired degree of neutralization by controlling the amount ratio between polycarboxylic acid and alkali, and is advantageous in that the gas barrier properties can be improved by neutralization as compared to the use of unneutralized carboxylic acid. The degree of neutralization is preferably more than 0% and not more than 20%, and more preferably more than 0% and not more than 18%, and particularly preferably in the range of 5-15%. When the degree of neutralization exceeds the above upper limit, the moisture proofness of the obtained gas barrier film tends to be insufficient.

Incidentally, the degree of neutralization can be determined using the following calculation equation.

$$\text{Degree of neutralization} = (A/B) \times 100(\%)$$

where A indicates the number of moles of the neutralized carboxylic groups in 1g of the partially neutralized polycarboxylic acid, and B indicates the number of moles of the carboxylic groups in 1g of the partially unneutralized polycarboxylic acid.

The polycarboxylic acid-base solution in the present invention may be the one containing polyalcohol in addition to the polycarboxylic acid-base polymer or the partially neutralized material of the polycarboxylic acid based polymer. Such a polyalcohol may be a compound containing two or more of hydroxyl groups in the molecule, and includes, for example, sugars, starches, polyvinyl alcohol (PVA), and the mixture of these materials, not particularly limited. Such sugars include monomeric sugars, oligosaccharides, and polysaccharides, as well as sugar alcohol, and various kinds of substitution products and derivatives. Such starches include the saccharized material of reduced starch. The saponification degree of such polyvinyl alcohol (PVA) is preferably 95% or more, more preferably 98% or more. The polymerization degree of such polyvinyl alcohol (PVA) is preferably in the range of 300-2, 500, more preferably 300-1,500.

The mixing ratio of the polycarboxylic acid or the partially neutralized material of the polycarboxylic acid and these polyalcohols is preferably in the range of 99:1 to 20:80 (weight ratio) from the viewpoint of the heat resistance of the obtained film, more preferably 95:5 to 40:60 (weight ratio), and particularly preferably 90:10 to 60:40 (weight ratio). A method for preparing such a mixture includes, for example, a method of dissolving each component, a method of mixing the aqueous solutions of each component, and a method of polymerizing (meth) acrylic acid monomer in an aqueous solution of polyalcohol, then partially neutralizing the produced polymer as necessary, not particularly limited.

A solvent used in the polycarboxylic acid-based solution in the present invention includes, for example, water, and a mixed solvent of, such as, water and alcohol. A small amount of metal salt of an inorganic acid soluble in water (for example, sodium acetate, and sodium benzoate) may be added to in the above solvent from the viewpoint of the acceleration of the reaction between polycarboxylic acid and polyalcohol.

In the present method, a mixture-deposited layer of the metal and the metal oxide is first formed on at least one surface of the polymer film substrate with a deposition method. Such a deposition method includes a known method such as a vacuum deposition method, a sputtering method, an ion plating method, and a chemical deposition method, not particularly limited.

The thickness of the mixture-deposited layer of a metal and metal oxide in the present invention is preferably 100-3,000 Å, more preferably 200-2, 000 Å, and particularly preferably 200-1, 000 Å. When the thickness of the vapor deposited layer is less than the lower limit above described, the moisture proofness of the obtained film tends to be reduced. On the contrary, when the thickness exceeds the above upper limit, a crack tends to be caused in the vapor deposited film, resulting in the reduction in moisture proofness.

In the present method, the polycarboxylic acid-based solution is then applied on the surface of the vapor deposited layer of a mixture. A method for applying the polycarboxylic acid-based solution includes an applying method using an apparatus such as an air knife coater, a kiss roll coater, a metalling bar coater, a gravure roll coater, a reverse roll coater, a dip coater, and a die coater, or the combination of these apparatuses, not particularly limited.

The concentration of the solid content in the polycarboxylic acid-based solution is preferably 1-30 wt.-%, more preferably 5-20%. The applied amount of the polycarboxylic acid-based solution is preferably 0.1-30 $g/m^2$ of the weight per $1m^2$ immediately after applying the polycarboxylic acid-based solution, more preferably 1-30 $g/m^2$, and particularly preferably 3-30 $g/m^2$.

In the present method, the polycarboxylic acid-based solution is preferably dried at a temperature of $\geq 50$ °C, more preferably within a temperature range of 100-300°C, and particularly preferably 140-250°C (heat treatment) to obtain a gas barrier film. In the present invention, the drying temperature is necessary to be $\geq 50$ °C. When the drying temperature is < 50 °C, it takes more times to dry the polycarboxylic acid-based solution, and the oxidation rate of the vapor deposited layer is somewhat less than at $\geq 50$ °C.

A method for drying the polycarboxylic acid-based solution in the present invention can includes a method in which e.g. water is dried by blowing hot air or by irradiating infra-red ray using, for example, an arch dryer, a straight bath dryer, a floating dryer, a tower dryer, a drum dryer, and the combination thereof. Specifically, a method in which e.g. water is dried in a drying atmosphere such as hot air and a heating furnace is preferable in that a gas barrier film having good visibility and good moisture proofness can be stably produced. Drying conditions in the drying atmosphere such as hot air and a heating furnace are preferably at a temperature range of 140-250 °C, and for a time period of 1 second to 4 hours, more preferably at a temperature range of 180-250 °C, and for a time period of 1 second to 30 minutes, and particularly preferably at a temperature range of 200-250 °C, and for a time period of 10 seconds to 30 minutes.

The above described method of the present invention allows the present gas barrier film described below to be obtained. That is, the gas barrier film of the invention is provided with a mixture-deposited layer of a metal and a metal oxide on at least one surface of a polymer film substrate. When the integration values of the XPS spectrums related to the metal and the metal oxide of the mixture-deposited layer described below are defined as $S_{Me}$ and $S_{MeO}$, respectively, the value of the integration value ratio ($S_{Meo}/S_{Me}$) in the mixture-deposited layer described below is 1.5-100. Moreover, a resin layer formed using a polycarboxylic acid-based solution is laminated on at least one surface of the mixture-deposited layer described below.

In the present invention, the value of the integration value ratio ($S_{Meo}/S_{Me}$) in the above mixture-deposited layer is 1.5-100, preferably 3-50, and particularly preferably 5-20. When it is < 1.5, the moisture proofness of the obtained gas barrier film is insufficient. On the contrary, when it exceeds 100, the flex resistance of the obtained gas barrier film is reduced.

In the present invention, the resin layer, which is described below and is formed using the polycarboxylic acid-based solution described above is laminated on at least one surface of the mixture-deposited layer. Such a resin layer is preferably the one obtained by drying the polycarboxylic acid-based solution at a temperature of $\geq 50$ °C. The thickness of such a resin layer is preferably 0.05-50 $\mu$m, more preferably 0.1-5 $\mu$m, and particularly preferably 0.1-2 $\mu$m.

In the present gas barrier film, the metal and the metal oxide the mixture-deposited layer are preferably aluminum, and aluminum oxide, respectively.

Furthermore, in the gas barrier film of the present invention, the water vapor permeability is $\leq 0.10$ $g/m^2 \cdot day$, and preferably $\leq 0.05 g/m^2 \cdot day$.

In addition, the present gas barrier film is preferably obtained by forming a mixture-deposited layer of a metal and a metal oxide on at least one surface of the polymer film substrate with a deposition method; by thereafter applying a polycarboxylic acid-based solution on the surface of the mixture-deposited layer; and by subsequently drying the solution at a temperature of 50 °C or more to further oxidize the mixture-deposited layer.

The present gas barrier film may be provided with a layer containing a polyvalent metal compound described below, a seal layer, and protective layer in addition to the polymer film substrate, the mixture-deposited layer, and the resin layer which are described above.

The present gas barrier film may be provided with a layer containing a polyvalent metal compound as a layer abutting to the resin layer to improve the gas barrier properties. Such a polyvalent metal compound includes the elemental substance of a polyvalent metal having a metal ion valence of $\geq 2$, and the compound thereof. Such a polyvalent metal can include, for example, alkali earth metal such as berylium, magnesium and calcium; a transition metal such as titan, zirconium, chromium, manganese, iron, cobalt, nickel, copper and zinc; and aluminum. Such a polyvalent metal compound can include, for example, the oxide, hydroxide, carbonate, organic acid salt, inorganic acid salt of the above polyvalent metal, ammonium complexes of the other polyvalent metal, the secondary to quaternary amine complexes of polyvalent metal, and the carbonate and organic acid salt of these complexes. Examples of such an organic acid salt include acetate, oxalate, citrate, lactate, phosphate, phosphite, hypophosphite, stearate and monoethylene unsaturated carboxylate. Examples of such an inorganic acid salt can include chloride, sulfate and nitrate. The other polyvalent metal compound can include alkyl alkoxide of a polyvalent metal.

The present gas barrier film may be provided with a seal layer to have heat seal properties. A resin used in such a seal layer includes, for example, polyethylene resin such as low density polyethylene (LDPE), linear low density polyethylene (LLDPE), high density polyethylene (HDPE), and ethylene-vinyl acetate copolymer (EVA) ; and polyacrylonitrile (PAN) . Among these, LLDPE, LDPE, and HDPE are preferably used from the viewpoint of heat seal strength. The thickness of such a seal layer is preferably 10-100 $\mu$m, more preferably 10-90 $\mu$m, particularly preferably 10-70 $\mu$m, not particularly limited.

Furthermore, the gas barrier film of the present invention may be provided with a protective layer on the outer surface on the other side of the seal layer to improve the strength of the film. A resin used in such a protective layer can include, for example, polyamide such as nylon 6, nylon 66, nylon 6/66 copolymer, nylon 6/12 copolymer, polyethylene terephthalate (PET), polyethylene naphthalate (PEN), polybutylene terephthalate (PBT), polycarbonate, poly4-methylpentene-1, polyphenylene sulfide, polypropylene, polyimide, and polyacrylonitrile (PAN). The thickness of such a protective layer is preferably 5-500 $\mu$m, more preferably 10-100 $\mu$m, and particularly preferably 10-30 $\mu$m, not particularly limited.

**Examples**

The present invention will be specifically described below based on examples and comparative examples, but is not limited to the examples. An integration value ratio ($S_{Meo}/S_{Me}$) of the metal and metal oxide of the mixture-deposited layer (vapor deposited layer), the oxygen permeability, water vapor permeability, and visibility of the gas barrier film were measured and evaluated with each of the following methods.

(i) Integration value ratio ($S_{Meo}/S_{Me}$) of the metal and metal oxide of the mixture-deposited layer (vapor deposited layer)

Depth profile measurement was carried out using an apparatus for depth profile measurement (5400MC: available from Physical Electronics, Inc.) under conditions that an X-ray source is MgK$\alpha$, a detection depth is 4-5 nm, and a sputtering rate is about 2.5 nm/min (SiO$_2$ conversion) to obtain an XPS spectrum. Subsequently, the integration values ($S_{Me}$, $S_{MeO}$) of the XPS spectrum of the metal and metal oxide of the mixture-deposited layer were determined from the obtained XPS spectrum. Then, the integration value ratio ($S_{MeO}/S_{Me}$) of the metal and metal oxide of the mixture-deposited layer was determined from the obtained values.

(ii) Oxygen permeability of the gas barrier film

Conforming to the method described in ASTM D 3985, the oxygen permeability of the gas barrier film was measured using an oxygen permeation instrument (™OX-TRAN 2/20 : available from MOCON, Inc.) under conditions including a temperature of 30°C, a sample area of 50cm$^2$, and a relative humidity (RH) of 80% on both sides.

(iii) Water vapor permeability of the gas barrier film

Conforming to the method described in JIS Z-0208, the water vapor permeability of the gas barrier film was measured using a water vapor permeability measuring apparatus (™PERMATRAN-W 3/31: available from MOCON, Inc.) under conditions including a temperature of 40°C, a sample area of 50 cm$^2$, relative humidity (RH) of 90% on one side, and relative humidity (RH) of 0% on the other side.

(iv) Visibility of the gas barrier film

Conforming to the method described in JIS K 7361, the all light beam permeability of the gas barrier film was measured using a turbidimeter (NDH2000 : available from Nippon Denshoku Industries Co., Ltd.) under conditions including a temperature of 23°C and relative humidity of 50%. It was determined that visibility was available (A) when the all light beam permeability of the gas barrier film was ≥ 35%, and not available (C) when < 35%.

(Example 1)

A calculated amount of sodium hydroxide (available from Wako Pure Chemical Industries, Ltd.) was first added to a 25 wt.-% aqueous solution of polyacrylic acid (PAA) (available from TOAGOSEI CO. LTD.) having a viscosity of 8, 000-12, 000 mPa·s at 30 °C and a number average molecular weight of 150,000 so as to obtain an aqueous solution of a PAA partially neutralized material having a neutralization degree of 5%.

Sodium hypophosphite (available from Wako Pure Chemical Industries, Ltd.) was then added to the obtained aqueous solution in an equivalent amount of 2 wt.-% of a polyacrylic acid solid content. Thereafter, the solid content concentration was adjusted to 10 wt.-%. Subsequently, an aqueous solution 1 of a PAA partially neutralized material having a solid content concentration of 10% by weight which contains a mixture of a PAA partially neutralized material and the saccharized material of reduced starch with a weight ratio of 80:20 on a solid content basis was prepared by adding the saccharized material of reduced starch after changing the solid content concentration of the reduced starch from 70 toto 10 wt.-%.

Then, the surface of the mixture-deposited layer of a mixture-deposited PET 1 (1015MT: available from TORAY ADVANCED FILM Co. LTD.), which is formed by depositing the mixture of aluminum and aluminum oxide in a thickness of 50nm (500 Å) on a polyethylene terephthalate (PET) film having a thickness of 12 μm, was coated with the aqueous solution 1 of the PAA partially neutralized material with a Mayer Bar (12 g/m$^2$ immediately after applying the aqueous solution 1 of the PAA partially neutralized material) using a table coater (K303 Proofer: available from RK Print-Coat Instrument Corporation). This mixture-deposited film was dried in a gear oven at a temperature of 200 °C for 15 minutes (heat-treated) to obtain a gas barrier film on which a resin layer 1 having a thickness of 1 μm was formed.

(Example 2)

A gas barrier film was obtained in the same manner as in Example 1 except that a mixture-deposited PET 2 (1015HT: available from TORAY ADVANCED FILM Co. LTD.) was used in place of the mixture-deposited PET 1 as a mixture-deposited PET.

(Example 3)

A polyethylene (PE) film (TUX-HC: available from TOHCELLO CO., LTD) having a thickness of 50 μm was laminated on the resin layer 1 of the gas barrier film obtained in Example 1 to obtain a gas barrier film, laminating a urethane-base adhesive layer (main agent: TM-250HV, hardener: CAT-RT86L-60: available from Toyo-Morton Ltd.) having a thickness of 2 μm in-between.

(Example 4)

A nylon (Ny) film (BONYL-RX: available from KOHJIN Co., Ltd.) having a thickness of 25 μm was laminated on the PET film surface of the gas barrier film obtained in Example 3 on which aluminum and aluminum oxide were not deposited to obtain a gas barrier film, laminating a urethane-base adhesive layer (main agent: TM-250HV, hardener: CAT-RT86L-60: available from Toyo-Morton Ltd.) having a thickness of 2 μm in between.

(Example 5)

The PAA used in Example 1 was partially neutralized by using a calculated amount of sodium hydroxide (sodium hypophosphite was not added) so as to have a neutralization degree of 5%. Thereafter, the solid content concentration was controlled to prepare an aqueous solution 2 of the PAA partially neutralized material (having a solid content concentration of 10 wt.-%).

Then, the surface of the mixture-deposited layer of the mixture-deposited PET 1 (1015MT: available from TORAY ADVANCED FILM Co. LTD.) was coated with the aqueous solution 2 of the PAA partially neutralized material with a Mayer Bar (12g/m$^2$ immediately after applying the aqueous solution 2 of the PAA partially neutralized material) using a table coater. The solution was subsequently dried at a temperature of 80 °C for 10 seconds to form a resin layer 2.

A gas barrier film was obtained by coating the resin layer 2 with a mixture (3 g of zinc oxide particles to 2 g of a polyester-based resin) of zinc oxide particle (available from Wako Pure Chemical Industries, Ltd.) and a polyester-based resin to form a layer containing zinc oxide.

(Example 6)

A gas barrier film was obtained in the same manner as in Example 5 except that magnesium oxide particles were used in place of the zinc oxide particles.

(Example 7)

A polyethylene (PE) film (TUX-HC: available from TOHCELLO CO., LTD) having a thickness of 50 $\mu$m was laminated on the zinc oxide containing layer of the gas barrier film obtained in Example 5 to obtain a gas barrier film, laminating a urethane-base adhesive layer (main agent: TM-250HV, hardener: CAT-RT86L-60: available from Toyo-Morton Ltd.) having a thickness of 2 $\mu$m inbetween.

(Example 8)

A polyethylene (PE) film (TUX-HC: available from TOHCELLO CO., LTD) having a thickness of 50 $\mu$m was laminated on the magnesium oxide containing layer of the gas barrier film obtained in Example 6 to obtain a gas barrier film, laminating a urethane-base adhesive layer (main agent: TM-250HV, hardener: CAT-RT86L-60: available from Toyo-Morton Ltd.) having a thickness of 2 $\mu$m inbetween.

(Comparative Example 1)

An aluminum-vapor deposited PET film (VM-PET1510: available from TORAY ADVANCED FILM Co. LTD.), which is produced by forming aluminum-vapor deposited layer having a thickness of 50nm (500Å) on a polyethylene terephthalate (PET) film having a thickness of 12 $\mu$m, was used.

(Comparative Example 2)

A SiO$_x$-vapor deposited PET film (MOS-TH: available from Oike & Co., Ltd.), which is produced by forming SiO$_x$-vapor deposited layer having a thickness of 80 nm (800 Å) on a polyethylene terephthalate (PET) film having a thickness of 12 $\mu$m, was used.

(Comparative Example 3)

An Al$_2$O$_3$-vapor deposited PET film (1011HG: available from TORAY ADVANCED FILM Co. LTD.), which is produced by forming Al$_2$O$_3$-vapor deposited layer having a thickness of 25 nm (250 Å) on a polyethylene terephthalate (PET) film having a thickness of 12 $\mu$m, was used.

(Comparative Example 4)

A mixture-deposited PET 1 (1015MT: available from TORAY ADVANCED FILM Co. LTD.), which is produced by vapor-depositing a mixture of aluminum and aluminum oxide in a thickness of 50 nm (500 Å) on a polyethylene terephthalate (PET) film having a thickness of 12 $\mu$m, was used.

(Comparative Example 5)

A gas barrier film was obtained in the same manner as that of Example 1 except that an aluminum-vapor deposited PET film (VM-PET1510: available from TORAY ADVANCED FILM Co. LTD.) was used as a vapor deposited PET in place of the mixture-deposited PET 1.

(Comparative Example 6)

A gas barrier film was obtained in the same manner as that of Example 1 except that the SiO$_x$-vapor deposited PET film (MOS-TH: available from Oike & Co., Ltd.) was used as a vapor deposited PET in place of the mixture-deposited PET 1.

(Comparative Example 7)

A gas barrier film was obtained in the same manner as that of Example 1 except that the $Al_2O_3$-vapor deposited PET film (1011HG: available from TORAY ADVANCED FILM Co. LTD.) was used as a vapor deposited PET in place of the mixture-deposited PET 1.

<Evaluation result>

The integration value ratio ($S_{Meo}/S_{Me}$) of the metal and metal oxide of the mixture-deposited layer (vapor deposited layer), oxygen permeability, water vapor permeability, and visibility of the gas barrier film obtained in Examples 1-8 and Comparative Examples 1-7 are as shown in Table 1.

[Table 1]

| | Layer construction | Integration value ratio of the metal and metal oxide of the mixture-deposited layer ($S_{MeO}/S_{Me}$) | Oxygen permeability ($cm^3/m^2 \cdot day \cdot atm$) | Water vapor permeability ($g/m^2 \cdot day$) | Visibility |
|---|---|---|---|---|---|
| Example 1 | PET/AL, $Al_2O_3$ mixture-deposited 1/resin layer 1 | 14 | <0.01 | 0.05 | A |
| Example 2 | PET/AL, $Al_2O_3$ mixture-deposited 2/resin layer 1 | 8 | <0.01 | 0.05 | A |
| Example 3 | PET/AL, $Al_2O_3$ mixture-deposited 1/resin layer 1/PE | 14 | <0.01 | 0.05 | A |
| Example 4 | Ny/PET/AL, $Al_2O_3$ mixture-deposited 1/resin layer 1/PE | 14 | <0.01 | 0.05 | A |
| Example 5 | PET/AL, $Al_2O_3$ mixture-deposited 1/resin layer 2/ZnO | 14 | <0.01 | 0.05 | A |
| Example 6 | PET/AL, $Al_2O_3$ mixture-deposited 1/resin layer 2/MgO | 14 | <0.01 | 0.05 | A |
| Example 7 | PET/AL, $Al_2O_3$ mixture-deposited 1/resin layer 2/ZnO/PE | 14 | <0.01 | 0.05 | A |
| Example 8 | PET/AL, $Al_2O_3$ mixture-deposited 1/resin layer 2/MgO/PE | 14 | <0.01 | 0.05 | A |
| Comparative Example 1 | PET/AL vapor deposited | 0.3 | 1.0 | 1.5 | C |
| Comparative Example 2 | PET/$SiO_2$ vapor deposited | 100< | 1.6 | 1.0 | A |
| Comparative Example 3 | PET/ $Al_2O_3$ vapor deposited | 100< | 1.5 | 1.0 | A |
| Comparative Example 4 | PET/AL, $Al_2O_3$ mixture-deposited 1 | 12 | 1.4 | 0.6 | A |

(continued)

| | Layer construction | Integration value ratio of the metal and metal oxide of the mixture-deposited layer $(S_{MeO}/S_{Me})$ | Oxygen permeability $(cm^3/m^2 \cdot day \cdot atm)$ | Water vapor permeability $(g/m^2 \cdot day)$ | Visibility |
|---|---|---|---|---|---|
| Comparative Example 5 | PET/ Al vapor deposited/resin layer 1 | 0.4 | 0.02 | 0.2 | C |
| Comparative Example 6 | PET/ SiO$_2$ vapor deposited/resin layer 1 | 100< | 0.02 | 0.2 | A |
| Comparative Example 7 | PET/ Al$_2$O$_3$ vapor deposited/resin layer 1 | 100< | 0.03 | 0.6 | A |

As seen from the result shown in Table 1, it is confirmed that the gas barrier film (Examples 1-8) is sufficiently excellent in the water vapor permeability and oxygen permeability, as well as the visibility of the gas barrier film.

**Industrial Applicability**

As described above, the present invention makes it possible to provide a gas barrier film having sufficiently excellent visibility as well as advanced moisture proofness.
Therefore, the gas barrier film of the present invention is useful as, for example, a packaging material or a moisture-proof material for a planar light-emitting device (EL), a vacuum thermal insulating material, an integrated circuit (IC), foods, medicines, and materials for living.

**Claims**

1. A gas barrier film having a water vapor permeability of 0.10 g/m$^2$·day or less at a temperature of 40°C and a relative humidity of 90% and comprising

   (i) a mixture-deposited layer made of a metal and a metal oxide provided on at least one surface of a polymer film substrate, and
   (ii) laminated on at least one surface of the layer (i), a resin layer formed using a polycarboxylic acid-based solution,

   wherein the integration value ratio ($S_{Meo}/S_{Me}$) in the layer (i) is 1.5-100, with $S_{Me}$ and $S_{Meo}$ being the integration values of the XPS spectra of the metal and the metal oxide of the layer (i), when MgK$\alpha$ is used as the X-ray source at a detection depth of 4 to 5 nm, and a sputtering rate of 2.5 nm/min (SiO$_2$ conversion).

2. The gas barrier film of claim 1, wherein the metal and metal oxide of the mixture-deposited layer are aluminum, and aluminum oxide, respectively.

3. The gas barrier film of claim 1, which is obtained by

   - forming a vapor deposited layer of a mixture of a metal and a metal oxide on at least one surface of a polymer film substrate with a vapor deposition method,
   - then applying a polycarboxylic acid-based solution on the surface of the mixture-deposited layer, and
   - subsequently drying the solution at a temperature of 50°C or more to further oxidize the mixture-deposited layer.

4. A method for producing the gas barrier film of claim 1, comprising:

   - forming a vapor deposited layer (i) made of a mixture of a metal and a metal oxide on at least one surface of the polymer film substrate by a vapor deposition method,

wherein the integration value ratio ($S_{Meo}/S_{Me}$) in the layer (i) is 1.5-100, with $S_{Me}$ and $S_{Meo}$ being the integration values of the XPS spectra of the metal and the metal oxide of the layer (i), when MgK$\alpha$ is used as the X-ray source at a detection depth of 4 to 5 nm, and a sputtering rate of 2.5 nm/min ($SiO_2$ conversion);
- applying a polycarboxylic acid-based solution on the surface of the layer (i); and
- subsequently drying the solution at a temperature of 50°C or more.

**5.** The method of claim 4, wherein a gas barrier film having a water vapor permeability of 0.10g/m$^2$ day or less at a temperature of 40°C and at a relative humidity of 90% is formed by drying the polycarboxylic acid-based solution.

**Patentansprüche**

**1.** Gassperrfilm, der eine Wasserdampfdurchlässigkeit von 0,10 g/m$^2$·Tag oder weniger bei einer Temperatur von 40°C und einer relativen Luftfeuchtigkeit von 90% aufweist und umfasst

(i) eine aus einem Gemisch abgeschiedene Schicht aus einem Metall und einem Metalloxid, die auf mindestens einer Oberfläche eines Polymerfilmsubstrats bereitgestellt ist, und
(ii) eine auf mindestens eine Oberfläche der Schicht (i) laminierte Harzschicht, die unter Verwendung einer Lösung auf Polycarbonsäurebasis gebildet ist,

worin das Integrationswertverhältnis ($S_{Meo}/S_{Me}$) in der Schicht (i) 1,5-100 beträgt, wobei $S_{Me}$ und $S_{Meo}$ die Integrationswerte der XPS-Spektren des Metalls und des Metalloxids auf der Schicht (i) sind, wenn MgK$\alpha$ als Röntgenstrahlquelle bei einer Detektionstiefe von 4 bis 5 nm und einer Sputterrate von 2,5 nm/min ($SiO_2$-Umwandlung) verwendet wird.

**2.** Gassperrfilm gemäß Anspruch 1, worin das Metall und Metalloxid der aus einem Gemisch abgeschiedenen Schicht Aluminium bzw. Aluminiumoxid sind.

**3.** Gassperrfilm gemäß Anspruch 1, der erhalten ist durch

- Bilden einer aufgedampften Schicht aus einem Gemisch aus einem Metall und einem Metalloxid auf mindestens einer Oberfläche eines Polymerfilmsubstrats mittels eines Dampfabscheidungsverfahrens,
- anschließendes Auftragen einer Lösung auf Polycarbonsäurebasis auf die Oberfläche der aus einem Gemisch abgeschiedenen Schicht, und
- anschließendes Trocknen der Lösung bei einer Temperatur von 50°C oder mehr, so dass die aus einem Gemisch abgeschiedene Schicht weiter oxidiert.

**4.** Verfahren zur Herstellung des Gassperrfilms gemäß Anspruch 1, umfassend:

- Bilden einer aufgedampften Schicht (i) aus einem Gemisch aus einem Metall und einem Metalloxid auf mindestens einer Oberfläche des Polymerfilmsubstrats mittels eines Dampfabscheidungsverfahrens, worin das Integrationswertverhältnis ($S_{Meo}/S_{Me}$) in der Schicht (i) 1,5-100 beträgt, wobei $S_{Me}$ und $S_{Meo}$ die Integrationswerte der XPS-Spektren des Metalls und des Metalloxids der Schicht (i) sind, wenn MgK$\alpha$ als Röntgenstrahlquelle bei einer Detektionstiefe von 4 bis 5 nm und einer Sputterrate von 2,5 nm/min ($SiO_2$-Umwandlung) verwendet wird;
- Aufbringen einer Lösung auf Polycarbonsäurebasis auf die Oberfläche der Schicht (i); und
- anschließendes Trocknen der Lösung bei einer Temperatur von 50°C oder mehr.

**5.** Verfahren gemäß Anspruch 4, worin ein Gassperrfilm mit einer Wasserdampfdurchlässigkeit von 0,10 g/m$^2$·Tag oder weniger bei einer Temperatur von 40°C und einer relativen Luftfeuchtigkeit von 90% durch Trocknen der Lösung auf Polycarbonsäurebasis gebildet ist.

**Revendications**

**1.** Film formant barrière contre les gaz ayant une perméabilité à la vapeur d'eau de 0,10g/m$^2$·jour ou moins à une température de 40°C et à une humidité relative de 90 % et comprenant

(i) une couche de mélange déposé faite d'un métal et d'un oxyde de métal fournie sur au moins une surface d'un substrat de film polymère, et

(ii) stratifiée sur au moins une surface de la couche (i), une couche de résine formée en utilisant une solution à base d'acide polycarboxylique,

dans lequel le rapport de valeurs d'intégration ($S_{Meo}/S_{Me}$) dans la couche (i) est de 1,5 à 100, $S_{Me}$ et $S_{Meo}$ étant les valeurs d'intégration des spectres XPS du métal et de l'oxyde de métal de la couche (i), quand la **K**$\alpha$ du **Mg** est utilisée comme source de rayons X à une profondeur de détection de 4 à 5 nm, et à une vitesse de dépôt par pulvérisation de 2,5 nm/min (conversion de $SiO_2$).

2. Film formant barrière contre les gaz selon la revendication 1, dans lequel le métal et l'oxyde de métal de la couche de mélange déposé sont respectivement de l'aluminium et de l'oxyde d'aluminium.

3. Film formant barrière contre les gaz selon la revendication 1, qui est obtenu par

   - la formation d'une couche déposée en phase vapeur d'un mélange d'un métal et d'un oxyde de métal sur au moins une surface d'un substrat de film polymère avec un procédé de dépôt en phase vapeur,
   - ensuite l'application d'une solution à base d'acide polycarboxylique sur la surface de la couche de mélange déposé, et
   - par la suite le séchage de la solution à une température de 50°C ou plus pour oxyder davantage la couche de mélange déposé.

4. Procédé pour produire le film formant barrière contre les gaz selon la revendication 1, comprenant :

   - la formation d'une couche déposée en phase vapeur (i) faite d'un mélange d'un métal et d'un oxyde de métal sur au moins une surface du substrat de film polymère par un procédé de dépôt en phase vapeur,

   dans lequel le rapport de valeurs d'intégration ($S_{Meo}/S_{Me}$) dans la couche (i) est de 1,5 à 100, $S_{Me}$ et $S_{Meo}$ étant les valeurs d'intégration des spectres XPS du métal et de l'oxyde de métal de la couche (i), quand la **K**$\alpha$ du **Mg** est utilisée comme source de rayons X à une profondeur de détection de 4 à 5 nm, et à une vitesse de dépôt par pulvérisation de 2,5 nm/min (conversion de $SiO_2$) ;

   - l'application d'une solution à base d'acide polycarboxylique sur la surface de la couche (i) ; et
   - par la suite le séchage de la solution à une température de 50 °C ou plus.

5. Procédé selon la revendication 4, dans lequel un film formant barrière contre les gaz ayant une perméabilité à la vapeur d'eau de 0,10 g/m$^2$·jour ou moins à une température de 40°C et à une humidité relative de 90 % est formé par séchage de la solution à base d'acide polycarboxylique.

**EP 1 920 915 B1**

**REFERENCES CITED IN THE DESCRIPTION**

**Patent documents cited in the description**

- JP 8142255 A
- JP 8142256 A
- EP 0437946 A
- JP 62220330 A